# EUROPEAN PATENT SPECIFICATION

(11) **EP 1 385 200 B1**
(45) Date of publication and mention of the grant of the patent: **07.07.2010**
(21) Application number: 03447188.8
(22) Date of filing: 18.07.2003
(51) Int. Cl.: H01L 21/762, H01L 31/18, H01L 21/20

(54) **Method for making thin film devices intended for solar cells or SOI applications**
Verfahren zur Herstellung von Dünnschichtbauelementen für Solarzellen oder SOI-Anwendungen
Procédé de fabrication de dispositifs à couches minces pour cellules solaires ou applications SOI

(30) Priority: 24.07.2002 EP 02447146
(43) Date of publication of application: 28.01.2004
(73) Proprietor: IMEC, 3001 Leuven (BE)
(72) Inventor: Solanki, Chetan Singh, 3000 Leuven (BE); Bilyalov, Renat, 3390 Tielt-Winge (BE); Poortmans, Jef, 3010 Kessel-Lo (BE)
(74) Representative: Van Malderen, Joëlle

(56) References cited:
- EP-A- 1 132 952
- US-A- 5 391 257
- S. M. SZE: "Semiconductor Devices Physics and Technology" 1985, JOHN WILEY AND SONS , MURRAY HILL, NEW JERSEY, USA , XP002311145 ISBN: 0-471-87424-8 * page 441 - page 442; figure 11 *

## Description

### Field of the invention

The present invention is related to microelectronics and more particular to the field of thin film device applications such as silicon-on-insulator (SOI) structures or solar cells in particular. Furthermore, the present invention is relating to a manufacturing method of such devices.

### State of the art

The silicon wafers found in existing semiconductor devices usually have a thickness of several hundred microns. However, the electrically active domain of a wafer is limited to its surface, in fact, less than a few microns of thickness is needed. The remained part of a wafer is used as substrate. Unfortunately, this excess of material causes both a rise in power consumption and a fall in the operating speed of the device. The SOI wafers incorporate an insulating layer between its very thin (less than a few microns) active domain and its much thicker substrate. The substrate is isolated and can thus no longer deteriorate the speed or efficiency of the active layer.

Silicon on insulator technology (SOI) involves the formation of a monocrystalline silicon semi-conductor layer on an insulating material such as silicon oxide.

One important application of a thin film device is the manufacturing of solar cells. Solar cells usually comprise on the top of a silicon wafer an active surface in the form of a thin film device deposited on said silicon wafer.

During the conversion of light into electrical energy, as mentioned above, only the top few microns of said top layer are really active. The major part of this silicon wafer only provides mechanical strength to the device. This function can be achieved by any other low-cost substrate compatible to the production process. The requirements for such a substrate, excepted low cost, are high temperature stability (1100°C), matching of the thermal expansion coefficients and low impurity contents.

More generally, in the prior art, the preparation of a porous semiconductor layer on a substrate as a sacrificial layer for solar cell usually comprises several steps such as at least a porous semiconductor layer formation on an original substrate, epitaxial silicon layer deposition, device fabrication on said substrate and separation of the device from the original substrate and transfer to a foreign substrate in order to possibly re-use the original substrate. This sequence is largely illustrated in the documents USPN 6,258,698 (Iwasaki et al, Canon), USPN 6,211,038 (Nakagawa et al, Canon) and USPN 6,326,280 (Tayanaka, Sony Corporation).

In the prior art, several methods are known to separate thin (porous) semiconductor films from a substrate. All those methods use a lift-off or peeling-off process at the end of the production chain. The drawback of these methods is that during all the process steps, parameters such as temperature, pressure and chemicals are conditioned by the resistance of the original substrate. The film separation and its transfer is the last technological step that requires preserving the high-porous characteristics of the Si layer. The fact of maintaining said porous characteristics throughout many high-temperature steps allows only a narrow processing window in terms of process temperature and porosity. Moreover in said case, the transfer is difficult to achieve properly.

In particular, a lift-off process is described in EP-A-1132952 where it is shown that a thin porous silicon film of 5 to 50 µm can be separated from the silicon substrate whereon it is deposited. In such case, the substrate can be re-used many times for getting new porous silicon films. Other possible techniques for thin film separation are ion implantation or wafer bonding techniques.

In EP-A-0993029, a method is disclosed for the production of a crystalline semiconductor film. This is done by forming a porous layer on a semiconductor substrate, lifting-off the porous layer, and either before or after the lifting-off applying a thermal annealing step such that the porous layer is at least partially recrystallised. For the lift-off step a method is disclosed in which the porous layer is attached to a 'Hilfstrager', which can be translated as a 'sub-carrier', or a 'foreign substrate'. The porous layer is physically bonded or glued to said foreign substrate.

Document US-A-5,391,257 is describing a method for transferring a thin film to an alternate substrate. The transfer process step includes the use of three substrates in order to be applicable to the transfer of any thin film.

### Aims of the invention

The present invention aims to provide an easy method for the preparation of thin-film devices for structures being highly efficient and low-cost. Examples of such structures are silicon-on-insulator (SOI) structures or solar cells. The use of thin film in SOI structures in general and in solar cells in particular allows the reduction of the amount of material consumed per structure, which significantly reduces the high costs of the active substrate, while the quality of the film provides the good characteristics of the whole device.

It is a further aim of the present invention to reduce the impact of device processing steps on the original substrate, porous silicon layer, porous silicon layer formation, necessary glues and target substrate.

It is another further aim of the present invention to improve control on the production-and-transfer process of thin films.

### Summary of the invention

The present invention relates to a method for manufacturing a semiconductor device, said method comprising the following subsequent steps:
(a) formation of a porous semiconductor layer (1,2) in the form of a thin film (10) on an original substrate (3),
(b) said formation being immediately followed by the step of separation of said thin film (10) by a peeling-off process from said original substrate (3);
(c) the transfer of said thin film (10) to a dummy support (4), said thin film(10) being a free-standing thin film, not physically bonded or glued to said dummy support (4) but merely placed or positioned on it;
(d) fabrication of a semiconductor device (11) on top of said thin film (10);
(e) transfer and attachment of said semiconductor device formed on said thin film (12;10,11) onto a foreign substrate (8).

In particular, the document EP-A-1132952 is describing especially the production of thin porous films.

In the art, the term 'original substrate' has also been named 'mother substrate', 'start-substrate' or 'originating substrate'. The term 'dummy support' in the art can also be named 'intermediate support or substrate', 'support substrate', 'dummy substrate'. The term 'foreign substrate' in the art can also be named 'target substrate', 'final substrate' or 'end-substrate'. The foreign substrate can be any substrate, e.g. glass. More examples of possible substrates are given in EP-A-0767486 and in USPN-6,391,219, where the final substrate is called support substrate. To avoid any confusion, in the present context, the distinction between the dummy support and the final support is that the dummy support is a support on which the fabrication of a device can easily take place with full freedom of process parameters and/or without a negative impact of any device processing steps on the original substrate, porous silicon layer, porous silicon layer formation, necessary glues and/or target substrate. The dummy support is a support to which the porous layer is transferred intermediately without physical attachment thereto. The dummy substrate is providing the necessary support and/or mechanical strength to the porous layer(s) during fabrication thereon of a device. In the absence of such supportive material, the porous layer(s) might break during device fabrication because too fragile.

The method according to the present invention differs from methods known in the art in the sequence of its steps. It further differs from methods in the prior art by the fact that a device is fabricated on the thin film while placed on a support to which the thin film is not physically bonded and/or glued. In other words, the device is fabricated on a free-standing thin film. The advantageous effects that accompany these changes with respect to the prior art are discussed throughout the specification.

How to perform the different steps per se is well known in the art. For instance, several possible methods for steps (a) and/or (b) are disclosed in EP-A-0767486, EP-A-0993029, EP-A-1132952, USPN-6,391,219 and references cited herein. In an embodiment of the present invention, cleaved surfaces may be smoothened before further processing, as described for instance in USPN-6,391,219. In a preferred embodiment of the invention, the original substrate can be re-used directly and/or be prepared for re-use.

In accordance with the present invention, the fabrication of a device or at least part thereof takes place on a free-standing thin film, before transfer of film and device to a final substrate which becomes part of the final thin film device, preferably of low-cost but highly efficient.

Throughout steps (b) to (d), in the present context, the thin film is often referred to as a free-standing film, also after transfer to a dummy substrate in step (c). The term "free-standing" refers to the fact that the film is not attached or physically bonded to the dummy substrate but merely placed or positioned on it, possibly fixed in between two supports to give mechanical strength to the porous semiconductor layer.

The fabricated device to be transferred to the foreign substrate can be a non-finished or intermediate device. Some processing steps to for instance finish the device, in other words to achieve a properly working device, can be performed after bonding of the intermediate device on a foreign substrate. According to the present invention, at least those processing steps are performed on the free-standing device placed on (but not physically attached to) a dummy support that would otherwise be limited with respect to temperature and/or other process parameters. In a preferred embodiment of the invention, at least an epitaxial active semiconductor layer is fabricated on the free-standing thin device before transfer and attachment to a foreign substrate on which it is then finished.

According to a preferred embodiment of the present invention the steps (c) and (d) are performed twice, such that the repeated step (c) unveils the unprocessed side of the thin film after the first (d) step. In other words steps (c) and (d) can be repeated such that (d) is performed once on one side of the thin film and once on the other side of the thin film.

According to a preferred embodiment of the present invention, the step of the fabrication of a device comprises the deposition of an active semiconductor layer on said thin film. In another preferred embodiment this formation of said layer is further followed by the fabrication of a device, which can be contacted, on said active semiconductor layer. The device referred to in claim 1 can be any suitable device known in the art.

The lift-off process according to the present invention can be achieved by immersing the substrate in a HF solution in concentration between 12 and 35% and using current densities between 50 and 250 mA/cm² without changing any other parameters.

Preferably, the deposition of said active layer is performed by epitaxial Chemical Vapour Deposition (CVD).

The porous semiconductor layer according to the present invention can be a crystalline or amorphous semiconductor material including silicon germanium, III-V materials such as GaAs, InGaAs and semiconducting polymers.

The foreign substrate can be any substrate. Advantageously, the foreign substrate comprises a low-cost substrate such as glass or a polymeric material.

### Short description of the drawings

Fig. 1 represents two manufacturing sequences of the prior art for the fabrication of solar cells (PSI process [A-B-C-E-G] and ELTRAN® process [A-B-D-F-H]).

Fig. 2 represents the manufacturing sequence of the present invention for the fabrication of a solar cell.

Fig. 3 illustrates the process of porous film production where pore branching results in increased lateral porosity followed by the film separation (lift-off process). This process is described in detail in EP-A-1132952.

Fig. 4 is a picture of the free-standing thin film device after peeling and before the transfer to the support. The transfer can be done e.g. manually as shown.

Fig. 5 represents the set-up used for the porous semiconductor layer formation according to EP-A-1132952.

Fig. 6 is representing the dummy substrate to hold the porous semiconductor film during the epitaxial layer deposition. The porous film is not attached or physically bonded to the dummy substrate.

Fig. 7 represents an adhesived device on a foreign substrate.

### Detailed description of preferred embodiments

The widely known silicon on insulator (SOI) technology involves the formation of a monocrystalline semiconductor layer on an insulating material, such as silicon oxide or glass.

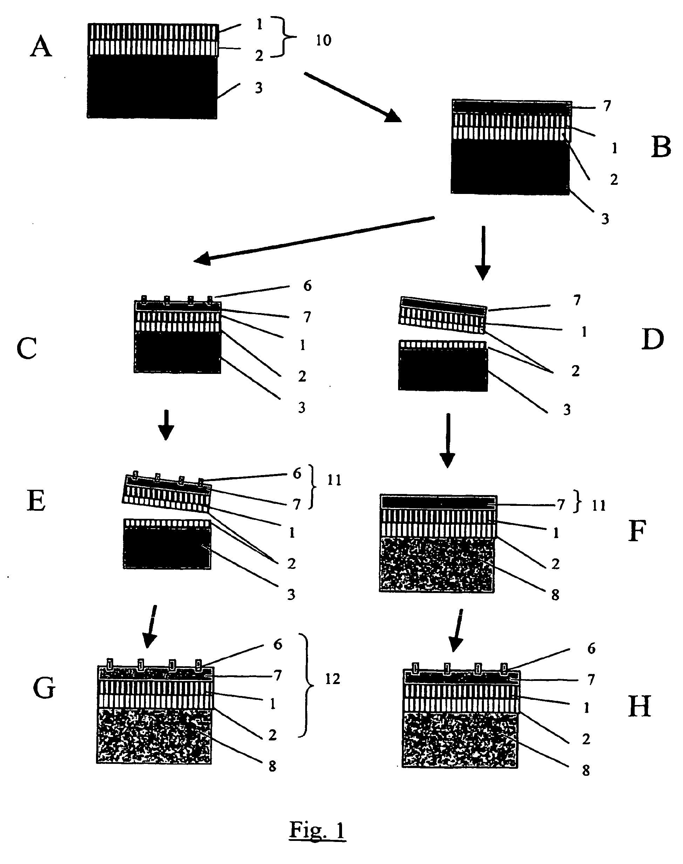

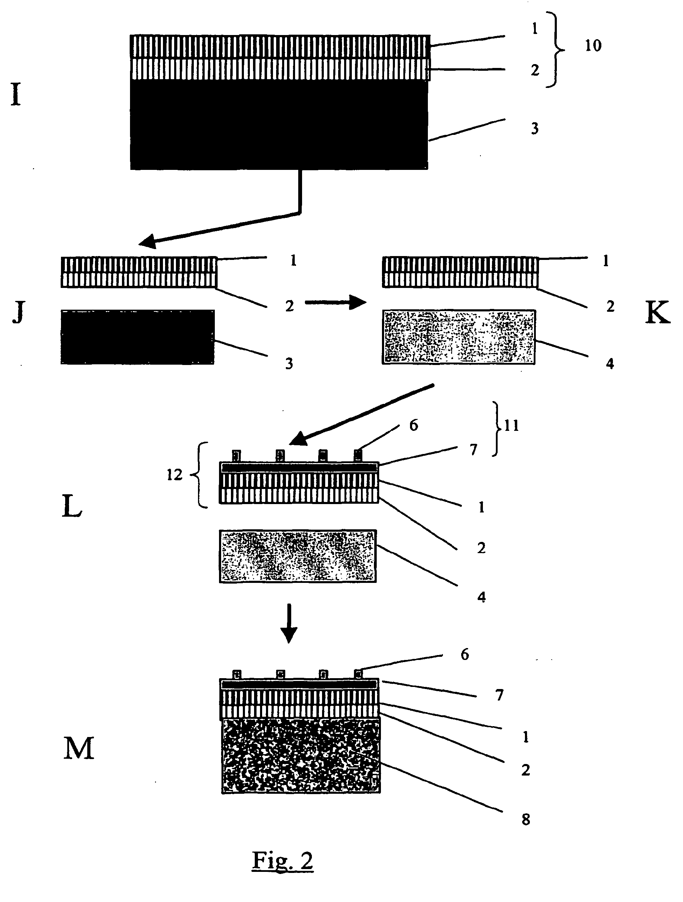

A particular embodiment of the present invention is related to the fabrication of solar cells which are described in details in Figs. 1 and 2.

The sequence of the prior art process is described in Fig. 1 while Fig. 2 represents the manufacturing process for the fabrication of a solar cell according to the present invention.

Fig. 1 [A-B-C-E-G] represents according to the prior art the preparation of a porous silicon layer (10, double layer 1+2) on a substrate (3) (Fig. 1A) followed by an epitaxial silicon layer (7) deposition (Fig. 1B), the contacted device (6) fabrication on said substrate (Fig. 1C) and finally the separation of said device (12=10+11) from the substrate (3) (Fig. 1E) and the transfer to a foreign substrate (8) in order to possibly re-use the original substrate (Fig. 1G).

Fig. 1 [A-B-D-F-H] represents a similar process according to the prior art wherein the preparation of a porous silicon layer (10, double layer 1+2) on a substrate (3) (Fig. 1A) is followed by an epitaxial silicon layer (7) deposition (Fig. 1B), the device (11) fabrication, which is not yet contacted, on said substrate and finally the separation of said device (12=10+11) from the substrate (3) (Fig. 1D) and the transfer to a foreign substrate (8) in order to possibly re-use the original substrate (Fig. 1F). The contacts of the device are then formed after the bonding on the foreign substrate. (Fig. 1H)

Fig. 2 is representing the sequence of the method for manufacturing a solar cell according to the present invention. Said method comprises the formation of a porous semiconductor layer (double layer 1+2, step I) in the form of a thin-film (10) on an original substrate (3), said formation being immediately followed by the separation of said thin-film (10) by a lift-off process from said original substrate (3) (step J), the transfer of said thin film (10) to a dummy substrate or support (4, step K), and the preparation of the device (11) including epitaxial silicon layer (7) deposition and preferably contact (6) fabrication (step L). Finally the transfer of the whole device to a foreign substrate (8) in order to realise the solar cell (step M). Possibly, contact (6) fabrication can take place after transfer of a non-finished device to the foreign substrate (8).

The preferred lift-off process involving the film separation from its substrate is described in details in Fig. (3). Other lift-off or peeling-off processes are well-known in the art.

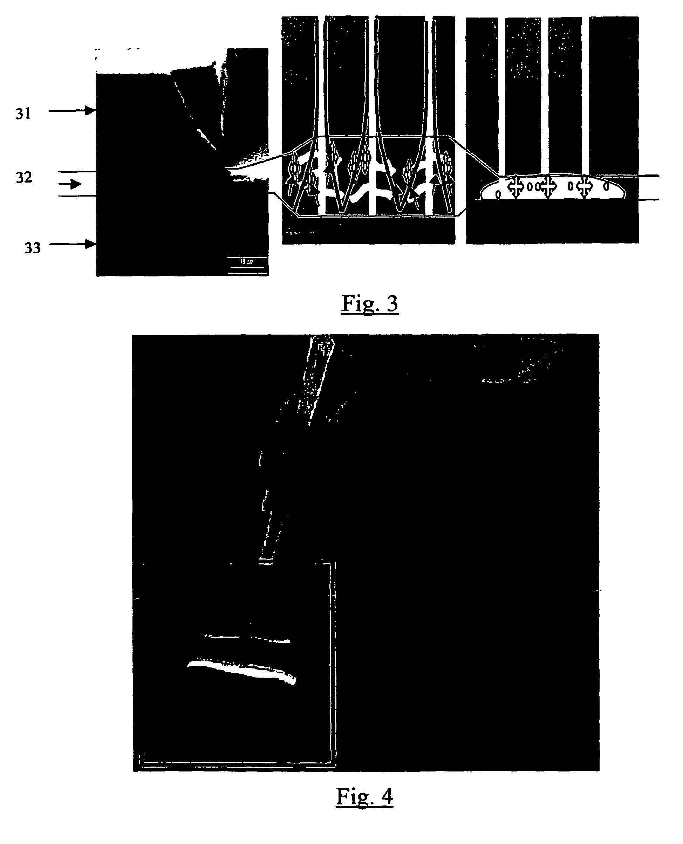

The pore formation according to this preferred lift-off process starts at a certain position, it goes straight down in the semiconductors as shown in Figure 3 (zone 31). When the pores are not deep enough, the reaction occurs at the bottom of the pore. At this time, there are sufficient fluoride ions available at the bottom but certainly less than the number of fluoride ions available at the surface since they have to diffuse through the pore to the point of reaction. Porosity of the layer increases with decrease in the concentration of HF in solution. Although the initial F-containing solution is not replaced, an in-situ change of concentration is obtained. Therefore, as we go deeper, porosity of the layer increases. The porosity gradient occurs from the point where the availability of the fluoride ion is affected by the diffusion through the pores.

As pores go sufficiently deep in silicon, the fluoride ion concentration at the point of reaction reduces to a very low level as compared to the surface concentration. This results in the shift of the point of reaction to a slightly higher level because of very high resistance of the lowest part of the pore. This shift in the reaction gives rise to the formation of the branches of the pores (zone 32). For every dissolution of a silicon atom, one hydrogen molecule results as a product of the electrochemical etching. The hydrogen molecules exert force on the walls of the pores. At some points, because of the branching of pores, the walls become very thin and not able to withstand the hydrodynamic pressure exerted by the hydrogen molecules. This results in horizontal cracks in the layer. The presence of sufficient horizontal cracks results in the separation of the layer from the substrate (zone 33).

An example of a free-standing thin film is described in Fig. 4 after the peeling-off and before the transfer to a support. The transfer can be performed manually, as shown. Alternatively the transfer can be performed with a device that holds the thin film by suction.

The approach of the present invention opens new possibilities in the formation of porous layers in form of thin films by proposing a new sequence for the preparation of free standing thin-film devices to be used for SOI structures or solar cells in particular. Examples of such porous semiconductor layers called hereunder as PSL could be crystalline and amorphous semiconductor material including silicon, germanium, III-V materials such as Ga As, InGaAs and semiconducting polymers.

In conventional techniques a double porosity layer is prepared by electrochemical etching and by changing one of the formation parameters such as the electrolytic current density or the HF concentration of the electrolytic solution.

The parameters of the porous silicon formation can also remain unchanged such that the separation is reached by allowing the current to flow for a sufficient amount of time (see EP-A-1132952).

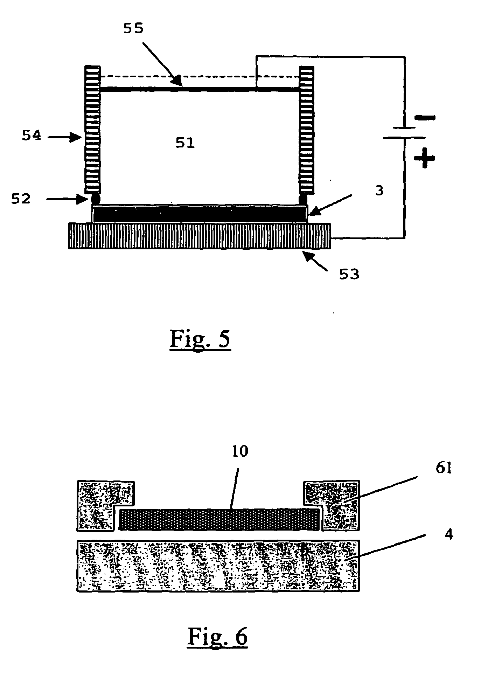

An example of a preferred set-up used for the formation of said double porous semiconductor layer has been described in detail in Fig. 5.

Fig. 5 is representing the set-up used for the formation of the porous semiconductor layer (PSL) according to such a preferred embodiment. In such a process, the platinum electrode (55), which is resistant against hydrofluoric acid, acts as a negative electrode. The bottom plate (53) (e.g. stainless steel plate), which is in contact with the silicon wafer (3) (polished side up), acts as a cathode. The rubber ring (52) prevents the outflow of the solution from the contact area of the Teflon® beaker (54) and wafer substrate (3). The rubber ring is kept under pressure by the beaker (54), which in turn is pressurised by a stainless steel threaded ring (not shown). The setup can comprise an etching solution (51).

According to the process of the present invention, after the preparation of the porous silicon layer, the film obtained is immediately separated from the substrate by a list of processes well-known in the art and then the fabrication of the device for the solar cell is carried out without permanently transferring the film on other substrates. This makes the process very simple because under these conditions, no worry is justified about the foreign as well as original substrate and glues on which the film has to be transferred. At the same time this gives a full freedom of process parameters. Since there is no limitation due to the foreign substrate and due to porosity of the semiconductor layer, any temperature cycle can be used.

In a preferred embodiment of the invention, the porous silicon layer is separated first with 100% probability (full control of the process) avoiding possible nuisances known to occur with certain prior art methods. For instance, if the porosity of the high porosity layer (2) is not high enough, separation after epitaxial deposition on the thin film in accordance with such prior art method may not be possible so that the lift-off process becomes unsuccessful. If the porosity of the high porosity layer is too high then it may separate unwantedly during the epitaxial layer deposition. The preferred embodiment according to the invention, wherein the formation and lift-off of porous layers (steps (a) and (b)) is in accordance with the method described in EP-A-1132952, circumvents said problems.

With the method according to the present invention there is also no limitation on the epitaxial layer deposition temperature which is in prior art cases can be limited due to thermal stability of high-porosity layer and/or on the thermal stability of substrate and glue.

Since the film is not physically attached to any substrate during epitaxy and cell fabrication, there are no concerns about the physical and chemical properties of any foreign substrate and/or glue and the impact of processing steps on these properties.

It has been shown that the growth of an epitaxial layer (7) on a porous thin film, which is attached, for instance glued on a substrate (e.g. dummy substrate) is not obvious, due to the impact on the glue of for instance the high temperatures used. (typically 1050 °C).

Both sides of the epitaxial layer are available during the complete cell fabrication process so there is more freedom of cell design and processing.

Preferably the fabrication of the device itself is performed by transferring the lift-off film (10) to a dummy support (4) in order to realise the epitaxial deposition (Fig. 6). The film can be clamped by for instance clamps (61). The dummy substrate can be any substrate that provides the necessary support during device fabrication and/or allows freedom of process parameters and/or does not interact with the thin film in a way that the latter would become bonded to the dummy support during said device fabrication. It is preferably resisting high temperatures (e.g. 1050°C). It is preferably inert to process steps which are performed during device fabrication while positioned on the dummy substrate. In a preferred embodiment of the invention the dummy substrate is a silicon substrate or a quartz substrate. In a preferred embodiment according to the invention, the dummy support may be re-used.

The present invention discloses a very attractive method for the preparation of low-cost, high quality structures, such as SOI structures or solar cells. The method according to the present invention clearly has many advantages over methods presently known in the art.

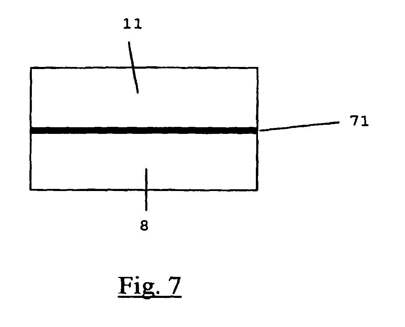

Figure 7 is representing a possible final structure such as a solar cell whereon the active device (11) has been attached by an adhesive (71) on a low-cost substrate (8).

According to a preferred embodiment related to the solar cell manufacturing process, the processing is more simple and provides a total freedom in terms of processing parameters, compared to the conventional techniques, e.g. using porous silicon sacrificial layers for thin film transfer processes. The transfer process according to the present invention occurs directly after the preparation of the porous silicon film on a dummy substrate which makes an intermediate layer as in the prior art useless. Such intermediate layers (e.g. hydrogen silsequioxane) require high temperature stability (1100°C) and matching thermal expansion coefficients as well as low impurity contents. For the substrate, similar requirements are necessary. Contrary thereto, for the process of the present invention, no transfer to the real substrate is performed and therefore no intermediate layer is used. The handling of the thin layer (film) is the biggest challenge but this difficulty is compensated by fewer constraints due to the reduced number of layers and more freedom in terms of process parameters. The monocrystalline Si thin film solar cells can be attached to any substrate (even flexible substrates) and the handling of this film remains the most critical point.

The present invention discloses a high quality method which allows production of a thin semiconductor film comprising a porous layer and a high quality epitaxial layer on top of said porous layer, and to transfer it onto a foreign substrate. The resulting device can be used in several applications comprising but not limited to the following:
- terrestrial solar cells, due to their low-cost,
- space solar cells due to their light weight (thin-film) combined with high efficiency,
- SOI structures due to their high quality of the epitaxial layers.

The following example is offered by way of illustration, not by way of limitation.

### Example 1: Fabrication of solar cells

A 20 µm porous silicon film is separated from highly doped P-type, <100> silicon by electrochemical etching in an electrolyte bath containing HF. After annealing of a porous silicon film at 1050°C in H₂, P-type silicon layer with 20 µm thickness is deposited using conventional Chemical Vapour Deposition (CVD). In the first trial, a simple two side-contacted solar cell without any photolithography is applied for such free-standing film. An efficiency of 10.6% is achieved for a small area cell (1 cm²). The other cell parameters are as follows: V_{oc} - 581.3 mV, I_{sc} - 30.29 mA/cm² and FF - 60.1 %. Internal Quantum Efficiency (IQE) analysis reveals that the spectral response of free-standing film with Al backside metallization is significantly increased in the infrared wavelength region as compared to the cell transferred to conventional ceramic substrates.

The process of the present invention comprises the following four steps of fabrication:

### a) Porous silicon formation and separation from the reusable (original) substrate. (See also EP-A-1132952)

For all experiments highly boron doped p-type mono-crystalline CZ-Si substrates with a resistivity in the range of 0.02-0.05 Ω-cm and an area of 5x5 cm² are used. Porous silicon formation is carried out in a conventional PTFE (Teflon) cell with a silicon sample as anode and a platinum counter electrode as shown in Fig. 5. The electrolyte contained of HF and acetic acid is used. Porous silicon formation is carried out at current density ranging from 50 to 250 mA/cm² and HF concentration ranging from 12 to 35 vol % at room temperature under background illumination. Step a) corresponds to steps (a) and (b) of the method of claim 1.

### b) Transfer of the porous semiconductor layer to a dummy substrate.

The porous semiconductor layer is not attached or physically bonded to the dummy substrate but fixed in between two supports to give mechanical strength to the porous semiconductor layer. Therefore we call it 'free-standing film' or 'free-standing solar cell'. Said step b) corresponds to step (c) of the method of claim 1. The transfer can be performed manually or with a device that holds the thin film by suction.

### c) Device fabrication

E.g. epitaxial silicon layer deposition: deposition of active layer can be carried out with and without pre-annealing of porous layer in H₂ ambient at 1050°C for 30 min. In the first case, the aim is to convert the porous silicon into quasi monocrystalline silicone (QMS) which provides a good seeding layer for a CVD layer deposition. An active layer of 10-30 microns is deposited using dichlorosilane (DCS) or trichlorosilane (TCS) at 1050°C and 1130°C respectively. The porous silicon film is kept (no permanent bonding) between two silicon substrates, with the window on the top substrate for CVD deposition.

One side contacted and two side contacted solar cells are fabricated while keeping the Porous-Silicon+Epi essentially free-standing (no permanent bonding to any substrate). Efficiency of 10.6% has been achieved on 1 cm² area.

Said step c) corresponds to step (d) of the method of claim 1.

### d) Attach or transfer solar cell on foreign substrate

In the final step of fabrication solar cell is transferred to a foreign substrate like Glass, Plastic, etc. using some adhesive as for instance glue. Said step d) corresponds to step (e) of the method of claim 1.

## Claims

1. A method for manufacturing a semiconductor device, said method comprising the following subsequent steps:
(a) formation of a porous semiconductor layer (1,2) in the form of a thin film (10) on an original substrate (3),
(b) said formation being immediately followed by the step of separation, of said thin film (10) by a peeling-off process from said original substrate (3);
(c) the transfer of said thin film (10) to a dummy support (4), said thin film(10) being a free-standing thin film, not physically bonded or glued to said dummy support (4) but merely placed or positioned on it;
(d) fabrication of a semiconductor device (11) on top of said thin film (10);
(e) transfer and attachment of said semiconductor device formed on said thin film (12;10,11) onto a foreign substrate (8).

2. Method according to claim 1, wherein in the step (b) the separation of said thin film (10) is performed by a peeling-off process, resulting in horizontal cracks in the thin film (10), in order to peel off said thin film (10) from said original substrate (3).

3. Method according to claim 1 or 2, wherein in steps (c) and (d) said thin film is fixed to said dummy support (4) in between two supports or clamped by clamps (61).

4. Method according to any of the preceding claims, wherein steps (c) and (d) are performed twice, once on one side of said thin film and once on said other side of said thin film.

5. Method according to any of the preceding claims, wherein the step of said fabrication of a device (11) comprises at least the deposition of an active semiconductor layer (7) on said thin film (10).

6. Method according to any of the preceding claims, wherein the deposition of said active semiconductor layer (7) is performed by epitaxial Chemical Vapour Deposition.

7. Method according to any of the preceding claims wherein the transferred device is a non-finished device that is further finished after attachment to said foreign substrate (8).

8. Method according to any of the preceding claims, wherein the peeling-off process is achieved by immersing the substrate (3) in a HF solution in concentration between 12 and 35% and using current densities between 50 and 250 mA/cm² without changing any other parameters.

9. Method according to any one of the preceding claims, wherein the porous semiconductor layer (1,2) is a double layer of crystalline or amorphous semiconductor material including silicon, germanium, III-V materials such as GaAs, InGaAs and semiconducting polymers.

10. A method as in any one of the preceding claims, wherein the foreign substrate (8) is glass or a polymeric material.

## Patentansprüche

1. Verfahren zur Herstellung einer Halbleitervorrichtung, wobei dieses Verfahren die folgenden Schritte umfasst:
(a) bilden einer porösen Halbleiterschicht (1, 2) in der Form eines Dünnfilms (10) auf einem Ausgangssubstrat (3);
(b) wobei auf dieses Bilden sofort der Schritt des Trennens dieses Dünnfilms (10) durch einen Abziehprozess vom besagten Ausgangssubstrat (3) folgt;
(c) das Übertragen dieses Dünnfilms (10) auf einen Dummy-Träger (4), wobei der besagte Dünnfilm (10) ein freistehender Dünnfilm ist, der nicht physikalisch an den besagten Dummy-Träger (4) gebunden oder geklebt ist sondern lediglich darauf angeordnet oder positioniert ist;
(d) herstellen einer Halbleitervorrichtung (11) auf der Oberseite des besagten Dünnfilms (10);
(e) übertragen und anbringen der besagten Halbleitervorrichtung die auf dem besagten Dünnfilm gebildet wurde (12; 10, 11), auf ein Fremdsubstrat (8).

2. Verfahren nach Anspruch 1, wobei im Schritt (b) das Trennen des besagten Dünnfilms (10) durch einen Abziehprozess durchgeführt wird, der zu waagerechten Sprüngen im Dünnfilm (10) führt, um den besagten Dünnfilm (10) vom besagten Ausgangssubstrat (3) abzuziehen.

3. Verfahren nach Anspruch 1 oder 2, wobei in den Schritten (c) und (d) der besagte Dünnfilm zwischen zwei Halterungen am besagten Dummy-Träger (4) fixiert wird oder durch Klammern (61) festgeklemmt wird.

4. Verfahren nach irgendeinem der vorhergehenden Ansprüche, wobei die Schritte (c) und (d) zweimal, einmal an einer Seite des besagten Dünnfilms und einmal an der anderen Seite des besagten Dünnfilmsdurchgeführt werden.

5. Verfahren nach irgendeinem der vorhergehenden Ansprüche, wobei der Schritt des besagten Herstellens einer Vorrichtung (11) zumindest das Ablagern einer aktiven Halbleiterschicht (7) auf dem besagten Dünnfilm (10) umfasst.

6. Verfahren nach irdendeinem der vorhergehenden Ansprüche wobei das Ablagern der besagten aktiven Halbleiterschicht (7) durch epitaxiale chemische Gasphasenabscheidung durchgeführt wird.

7. Verfahren nach irgendeinem der vorhergehenden Ansprüche, wobei die übertragene Vorrichtung eine nicht fertiggestellte Vorrichtung ist die nach der Anbringung am besagten Fremdsubstrat (8) weiter fertiggestellt wird.

8. Verfahren nach irdendeinem der vorhergehenden Ansprüche, wobei der Abziehprozess durch Eintauchen des Substrats (3) in eine HF-Lösung mit einer Konzentration zwischen 12 und 35 % und Verwenden von Stromdichten zwischen 50 und 250 mA/cm² ohne Veränderung jeglicher anderer Parameter erreicht wird.

9. Verfahren nach irgendeinem der vorhergehenden Ansprüche, wobei die poröse Halbleiterschicht (1, 2) eine Doppelschicht aus kristallinem oder amorphem Halbleitermaterial einschließlich Silizium-Germanium, III-V-Materialien wie etwa GaAs, InGaAs und halbleitenden Polymeren ist.

10. Verfahren nach irgendeinem der vorhergehenden Ansprüche, wobei das Fremdsubstrat (8) Glas oder ein Polymermaterial ist.

## Revendications

1. Procédé de fabrication d'un dispositif à semi-conducteur, ledit procédé comprenant les étapes consécutives suivantes :
(a) la formation d'une couche semi-conductrice poreuse (1, 2) sous la forme d'un film mince (10) sur un substrat d'origine (3),
(b) ladite formation étant immédiatement suivie par l'étape de séparation dudit film mince (10) par un processus de décollement dudit substrat d'origine (3) ;
(c) le transfert dudit film mince (10) vers un support factice (4), ledit film mince (10) étant un film mince autonome, non physiquement lié ou collé audit support factice (4), mais simplement placé ou positionné sur celui-ci ;
(d) la fabrication d'un dispositif à semi-conducteur (11) pardessus ledit film mince (10) ;
(e) le transfert et la fixation dudit dispositif à semi-conducteur formé sur ledit film mince (12 ; 10, 11) sur un substrat étranger (8).

2. Procédé selon la revendication 1, dans lequel dans l'étape (b), la séparation dudit film mince (10) est effectuée par un processus de décollement, aboutissant à des fissures horizontales dans le film mince (10), afin de décoller ledit film mince (10) dudit substrat d'origine (3).

3. Procédé selon la revendication 1 ou 2, dans lequel dans les étapes (c) et (d), ledit film mince est fixé audit support factice (4) entre deux supports ou serré par des pinces (61).

4. Procédé selon l'une quelconque des revendications précédentes, dans lequel les étapes (c) et (d) sont effectuées deux fois, une fois sur un côté dudit film mince et une fois sur ledit autre côté dudit film mince.

5. Procédé selon l'une quelconque des revendications précédentes, dans lequel l'étape de ladite fabrication d'un dispositif (11) comprend au moins le dépôt d'une couche semi-conductrice active (7) sur ledit film mince (10).

6. Procédé selon l'une quelconque des revendications précédentes, dans lequel le dépôt de ladite couche semi-conductrice active (7) est effectué par dépôt chimique en phase vapeur épitaxial.

7. Procédé selon l'une quelconque des revendications précédentes, dans lequel le dispositif transféré est un dispositif non fini qui est davantage fini après fixation audit substrat étranger (8).

8. Procédé selon l'une quelconque des revendications précédentes, dans lequel le processus de décollement est réalisé par immersion du substrat (3) dans une solution de HF à une concentration comprise entre 12 et 35 % et à l'aide de densités de courant comprises entre 50 et 250 mA/cm² sans changer aucun autre paramètre.

9. Procédé selon l'une quelconque des revendications précédentes, dans lequel la couche semi-conductrice poreuse (1, 2) est une couche double de matériau semi-conducteur cristallin ou amorphe incluant du silicium germanium, des matériaux III-V tels que GaAs, InGaAs et des polymères semiconducteurs.

10. Procédé selon l'une quelconque des revendications précédentes, dans lequel le substrat étranger (8) est du verre ou un matériau polymère.
